# DEMANDE DE BREVET EUROPEEN

(11) **EP 2 693 578 A1**
(43) Date de publication de la demande: **05.02.2014**
(21) Numéro de dépôt: 13178481.1
(22) Date de dépôt: 30.07.2013
(51) Int. Cl.: H02B 1/04, H02B 1/052, G01R 19/00

(54) **Système de mesure de la consommation électrique d'appareils modulaires dans un coffret**

(30) Priorité: 30.07.2012 FR 1257387
(71) Demandeur: Hager-Electro SAS, 67210 Obernai (FR)
(72) Inventeur: Baptiste, Jean-François, 67140 Andlau (FR); Baumann, Eric, 67610 La Wantzenau (FR); Artis, Cyril, 67870 Bischoffsheim (FR)
(74) Mandataire: Littolff, Denis

(57) **Abrégé**

Système de mesure de la consommation électrique d'au moins un groupe constitué d'au moins deux appareils électriques modulaires, lesdits appareils modulaires étant fixés sur au moins un rail en au moins une rangée, un groupe n'appartenant qu'à une rangée, comportant des moyens de mesure du courant et au moins une unité de traitement (5) du ou des courants mesurés, et des moyens de liaison (4) entre les moyens de mesure du courant et ladite unité de traitement (5).

Ce système comporte :
- un dispositif de mesure solidarisé à une rangée de manière amovible, disposé en amont immédiat d'au moins un groupe et doté de premiers moyens de mesure (3, 7) du courant consommé dans ledit groupe ;
- un système de signalisation visuelle (34) du groupe à mesurer, placé au niveau dudit dispositif de mesure ;
- des seconds moyens de mesure (2, 6) du courant pouvant être placés à distance du dispositif de mesure.

## Description

La présente invention a trait à un système de mesure de la consommation électrique, utilisable dans des installations électriques notamment domestiques et comportant en amont de chaque installation une pluralité d'appareils de protection organisés par circuits distincts, par exemple dévolus à des fonctions ou à des types de charges différentes.

L'idée à la base de l'invention est de mettre en oeuvre des moyens pour procéder à des mesures de consommation en vue d'obtenir des informations susceptibles d'aider à la gestion et au contrôle des consommations électriques, par exemple chez des particuliers.

La tendance générale du marché est actuellement d'offrir au consommateur la possibilité de gérer sa consommation en lui ouvrant l'accès à des informations résultant de mesures spécifiques plus ou moins variées sur son installation électrique. L'état des technologies actuel, tant sur le plan technique qu'économique, permet l'intégration extensive de moyens de traitements puissants dans le secteur de l'électricité domestique, intégration encore favorisée par l'essor de la domotique et la volonté des consommateurs de mieux maîtriser leurs coûts de consommation.

Les normes récentes ou en préparation traçant les politiques énergétiques du futur accompagnent d'ailleurs cette tendance, puisqu'elles visent à imposer des mesures de courant pour évaluer de façon distincte la consommation de quatre groupes de charges présentes dans les installations électriques usuelles, à savoir les charges correspondant respectivement au chauffage, aux prises de courant, à l'eau chaude sanitaire, et enfin au reste des dispositifs électriques équipant les habitats (éclairage...).

Compte tenu de l'organisation classique de la distribution d'électricité chez les particuliers, il semble naturel de procéder aux différentes mesures au niveau du tableau électrique, en général placé dans un coffret, et dans lequel sont regroupés les différents appareils électriques de protection (disjoncteurs, interrupteurs différentiels, ...) des circuits installés.

Ces appareils de protection, généralement modulaires, sont montés sur des rails horizontaux permettant de les disposer en rangées superposées, lesquelles peuvent comporter plusieurs appareils de protection par type de charge, selon l'organisation des circuits et la topologie de l'habitat.

L'objectif de l'invention est de promouvoir un système apte à réaliser les mesures nécessaires en impactant de manière minimale la configuration du tableau, qui obéit par ailleurs à bien d'autres contraintes et considérations d'installation devant être respectées.

Ainsi, la réalisation de ces mesures doit être considérée comme relevant de la mise en place d'une « couche » fonctionnelle supplémentaire, qui est cependant assujettie aux impératifs qui ont présidé jusqu'ici à la mise en oeuvre pratique de ces tableaux. On y trouve ainsi souvent plusieurs groupes d'appareillages de protection gérant des charges différentes sur une seule rangée, dont l'alimentation par une barre de pontage est une réalité qui doit être prise en considération, ainsi que l'existence de dispositifs d'alimentation de plusieurs rangées via une barre verticale.

Il existe par ailleurs déjà des systèmes de mesure implantés dans des tableaux électriques. Ceux-ci réalisent en général la mesure du courant, par exemple à l'aide de tores de mesure disposés sur les conducteurs dans lesquels le courant doit être mesuré. La mise en oeuvre peut s'avérer complexe dans la mesure où l'électricien doit sélectionner le ou les câbles dans lesquels la mesure du courant est souhaitée, de manière à éventuellement faire passer plusieurs conducteurs dans un même tore, puis à tenir compte de la situation telle que créée en vue du traitement ultérieur, qui consiste par exemple à effectuer des sommations pour aboutir à un résultat global.

L'espace étant restreint dans les coffrets, ce type de mise en oeuvre se heurte bien souvent à des problèmes de place pour le positionnement des tores, sans même parler de la nécessité de trouver un emplacement pour l'appareil de traitement des courants mesurés.

Alternativement, des compteurs sont parfois mis en place dans chaque rangée d'appareils de protection, permettant la mesure du courant passant dans les câbles qui lui sont raccordés. Le câblage d'une telle installation n'est en général pas aisé, et elle ne permet en tout état de cause pas de mesure sélective.

Il a également été proposé de mettre en place, selon une approche non globale, un capteur de mesure du courant sur le conducteur qui sort de chaque appareil de protection. Dans ce cas, pour mesurer le courant consommé par un groupe d'appareils, chacun doit bien entendu être équipé d'un tel capteur, ce qui augmente sensiblement le coût global de l'installation et n'apporte aucune réponse à la question évoquée de la complexité de l'installation.

Les capteurs, installés dans ce cas entre les rangées d'appareils, doivent en effet trouver leur place dans un espace normalement dédié au passage des câbles, ce qui rend l'installation de ces derniers plus compliquée, plus susceptible de générer des erreurs de câblage d'une part, et d'augmenter les échauffements en accroissant le confinement dans le tableau d'autre part.

Enfin, il existe des appareils modulaires qui permettent des mesures de paramètres visant à évaluer la consommation, installés à ce titre sur le rail définissant une rangée, et reliés électriquement à des capteurs tels que des tores de mesure de courant placés sur les entrée ou conducteurs en amont des quels on cherche à obtenir une mesure. Cette logique d'assemblage ne permet cependant notamment pas d'identifier facilement les groupes d'appareils sur lesquels les mesures sont faites.

La présente invention, qui permet de simplifier la réalisation des mesures désirées dans une armoire électrique classique, offre au surplus à l'installateur comme à l'utilisateur des informations précises sur des groupes identifiés, regroupés par exemple par fonction.

A cet effet, le système de l'invention, permettant la mesure de la consommation électrique d'au moins un groupe constitué d'au moins deux appareils électriques modulaires, lesdits appareils modulaires étant fixés sur au moins un rail en au moins une rangée, un groupe n'appartenant qu'à une rangée, comporte des moyens de mesure du courant et au moins une unité de traitement du ou des courants mesurés, et des moyens de liaison entre les moyens de mesure du courant et ladite unité de traitement.

Il se caractérise à titre principal en qu'il comporte :
- un dispositif de mesure solidarisé à une rangée de manière amovible, disposé en amont immédiat d'au moins un groupe et doté de premiers moyens de mesure du courant consommé dans ledit groupe ;
- un système de signalisation visuelle du groupe à mesurer, placé au niveau dudit dispositif de mesure ;
- des seconds moyens de mesure du courant pouvant être placés à distance du dispositif de mesure.

Le positionnement particulier des dispositifs de mesure, en amont des groupes, peut permettre un fonctionnement en cascade dans l'hypothèse de plusieurs groupes : le dispositif de mesure situé le plus en aval, qui gère par conséquent le dernier groupe constitué de la rangée, mesure le courant de cet unique groupe. Le ou les dispositifs (ou les seconds moyens de mesure) situés plus en amont mesurent la somme des courants de tous les groupes placés en aval sur une rangée, et la mesure spécifique pour leur propre groupe est obtenue par soustraction avec les valeurs mesurées pour le ou les groupes situés plus loin dans la chaîne.

On peut en fait placer autant de dispositifs de mesure que de groupes de produits sur la rangée, car pour mesurer le courant consommé dans un groupe qui n'est pas le dernier de la rangée, il faut pouvoir disposer de la mesure du ou des groupes en aval.

Selon l'invention, en pratique, les seconds moyens de mesure du courant peuvent consister en un tore placé autour d'un conducteur d'alimentation.

Lesdits seconds moyens de mesure du courant peuvent alternativement ou simultanément consister en un tore placé sur un câble en sortie d'un appareil électrique pour mesurer la consommation d'un seul appareil.

Selon une configuration possible du système de mesure de l'invention, les seconds moyens de mesure sont placés en début de chaque rangée et peuvent alors être :
- disposés dans une barre d'alimentation de plusieurs rangées ; et/ou
- disposés dans une barre d'alimentation de plusieurs groupes ; et/ou
- intégrés dans un appareil de tête de rangée ; et/ou
- placés dans un appareil à boîtier modulaire placé entre l'appareil de tête de rangée et le groupe localisé immédiatement en aval ; et/ou
- intégrés à un dispositif connecté à l'entrée de l'appareil de tête de rangée.

En pratique, les moyens de mesure peuvent être reliés à l'unité de traitement par fil ou par liaison radio.

Par ailleurs, selon une possibilité, le dispositif de mesure du courant peut consister en un boîtier fixé sur la barre d'alimentation, au voisinage ou au contact d'au moins une portion de la face latérale en regard de ladite barre du boîtier du premier appareil du groupe.

Il surmonte alors la rangée d'appareils modulaires accolés sur la rangée, en laissant passer le ou les conducteur(s) de la barre d'alimentation qui réalise(nt) le pontage d'alimentation des appareils.

Dans cette hypothèse, selon une configuration possible, le système de signalisation visuelle du groupe peut consister en une feuille souple issue du boîtier et comportant une portion repliable parallèlement à la façade des appareils modulaires, en direction des appareils constituant le groupe.

Le reste de la feuille souple peut être coincé entre deux appareils accolés au contact de l'appareil le plus amont du groupe, ou prendre la forme d'une patte dépassant dudit boîtier et longeant une partie de sa façade.

Alternativement, le système de signalisation visuelle du groupe peut consister en un pictogramme placé sur le boitier indiquant la direction dans laquelle se trouvent, dans la rangée, les appareils constituant le groupe.

De préférence, toutefois, le dispositif de mesure du courant consiste en un appareil à boîtier modulaire.

L'utilisation d'un boîtier modulaire rend l'installation éminemment pratique, car le coffret électrique est spécifiquement prévu pour la fixation et/ou le démontage, immédiat(e) et sans outil, de tels appareils. La mesure des valeurs concernant chaque groupe peut ensuite se faire de différentes manières.

Selon une première configuration, lesdits premiers moyens de mesure du courant peuvent être disposés dans la face latérale du boîtier, en regard du ou des conducteurs d'alimentation des appareils du groupe localisé en aval.

Dans cette hypothèse, les premiers moyens de mesure du courant peuvent par exemple consister en au moins un capteur à effet Hall, positionné à proximité immédiate du conducteur dont il doit mesurer le courant.

Alternativement, les premiers moyens de mesure du courant peuvent consister en au moins un tore partiellement ouvert dans la direction des conducteurs d'alimentation, dépassant du boîtier de sorte qu'il puisse entourer au moins partiellement au moins un conducteur d'alimentation.

Cette solution, comme la précédente, présente l'avantage de ne pas nécessiter de modification majeure sur le système de distribution du courant, qui peut notamment prendre la forme d'une barre de pontage.

Selon une autre alternative encore, lesdits premiers moyens de mesure du courant peuvent comporter un conducteur passant dans un tore intégré au boîtier par phase d'alimentation, dont les extrémités libres dépassent de la face latérale du boîtier pour relier deux blocs adjacents par raccordement aux dispositifs de connexion d'entrée des appareils modulaire situés de part et d'autre du boîtier du dispositif de mesure ou à des dispositifs de connexion prévus dans deux portions d'une barre d'alimentation alimentant les deux groupes adjacents.

Plus précisément, lesdits conducteurs peuvent être logés dans une extension du boîtier d'allure parallèle à l'axe de la rangée, permettant leur guidage vers les dispositifs de connexion d'entrée. Dans cette hypothèse, la barre de pontage, si elle existe, est sectionnée au niveau de l'emplacement du produit modulaire contenant les seconds moyens de mesure du courant.

Le produit modulaire comporte alors un aspect en « T » adapté à sa connexion aux deux appareils modulaires adjacents ou aux deux portions de barre de pontage.

Selon une possibilité propre à l'invention, le dispositif de mesure peut comporter des moyens de visualisation disposés sur la façade du boîtier, et reliés à l'unité de traitement des courants mesurés.

Ces moyens de visualisation peuvent typiquement montrer la puissance consommée par au moins un groupe de produits adjacents.

De préférence, ces moyens de visualisation peuvent consister en un écran LCD.

Pour pouvoir choisir le groupe d'appareils dont la consommation doit être affichée, il faut bien entendu que le dispositif de mesure comporte des moyens de commande du groupe dont la consommation mesurée doit être affichée.

Selon une possibilité, ces moyens de commande peuvent consister en deux boutons alignés selon l'axe de la rangée et permettant d'indiquer le côté du groupe sélectionné.

Dans cette configuration, un appui sur le bouton situé à gauche dans la façade du produit intermédiaire permet d'afficher la puissance du groupe situé à gauche dudit produit dans la rangée, alors qu'un appui sur le bouton situé à droite permet d'afficher la consommation du groupe qui est disposé à droite.

L'invention va à présent être décrite plus en détail, en référence aux figures annexées, pour lesquelles :
- la figure 1 est une représentation schématique de la mise en oeuvre de l'invention pour une rangée d'appareils de protection situés dans un coffret de distribution et comportant deux groupes d'appareils distincts ;
- la figure 2 montre un système de mesure élargi, qui s'applique à deux rangées et quatre groupes d'appareils ;
- la figure 3 reprend l'exemple de la figure 1, en précisant la structure des moyens de mesure ;
- la figure 4 représente schématiquement un appareil de mesure modulaire selon l'invention ;
- la figure 5 montre la mise en oeuvre des premiers dispositifs à moyen de mesure dans le cadre d'une barre d'alimentation verticale ;
- la figure 6 représente possible d'appareils modulaires à seconds moyens de mesure selon l'invention, dans une configuration équipée de capteurs à effet Hall ;
- les figures 7 et 8 montrent une configuration à bobinage et fourche ou tore partiel dépassant de la face du boîtier en regard de la barre de pontage des produits situés dans la rangée ; et
- la figure 9 montre encore une variante possible, avec un tore et deux conducteurs dépassant de sa face en regard de l'alimentation, destinés à être connectés aux deux produits adjacents ; et
- la figure 10 représente une configuration alternative « en feuille ».

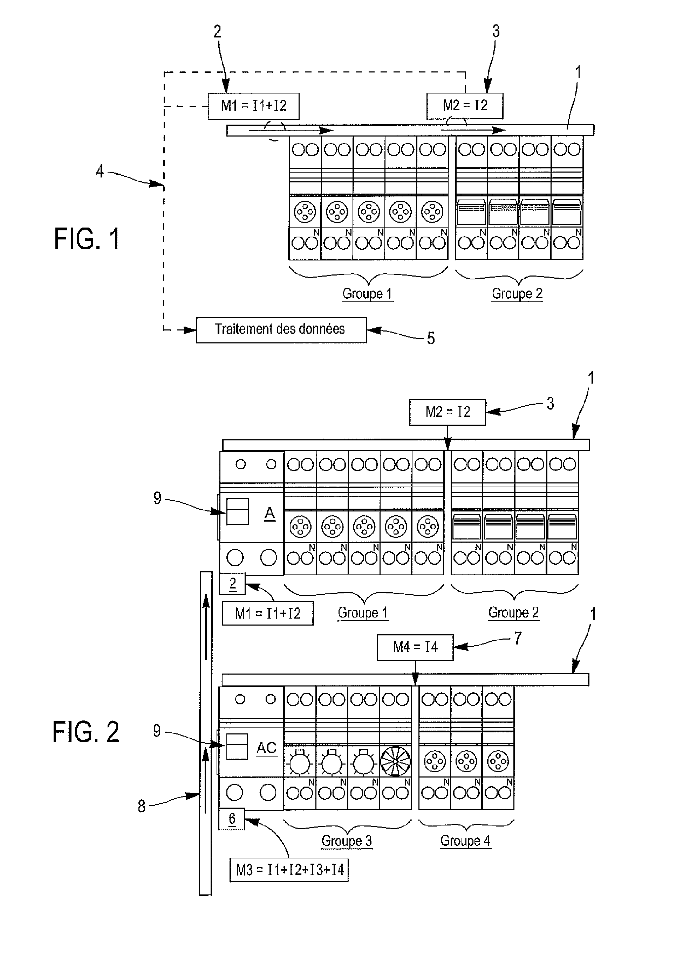

En référence à la figure 1, deux groupes d'appareils modulaires (groupe 1, groupe 2) fixés sur un même rail, en une seule rangée, sont alimentés par une barre de distribution (1), deux moyens de mesure (2, 3) étant prévus pour la mesure du courant véhiculé dans la barre (1) (symbolisé par des flèches), dans lesdits groupes. Ces moyens de mesure sont situés immédiatement en amont des deux groupes 1 et 2, les moyens de mesure (3) étant situés immédiatement à gauche du groupe 2, alors que les moyens de mesure (2) sont situés immédiatement en amont du groupe 1.

Les moyens de mesure (3) permettent la mesure M2 du courant alimentant le groupe (2), cette mesure M2 représentant par conséquent le courant I2 véhiculé vers les appareils du groupe 2. La mesure M1, située en amont de la mesure M2, correspondant par conséquent à la somme des courants I1 véhiculés vers les appareils du groupe (1) et I2.

L'information correspondant aux deux mesures M1 et M2 est transférée par les moyens de liaison (4), par exemple des fils formant un bus de liaison, vers une unité (5) collectant ces données et réalisant leur traitement.

La figure 2 représente une configuration à quatre groupes (groupe 1, groupe 2, groupe 3 et groupe 4) fonctionnant sur un principe identique, en ajoutant une rangée supplémentaire, c'est-à-dire une ligne supplémentaire si l'on a une vision matricielle de la situation, les éléments de la matrice étant les points ou moyens de mesure.

Une autre différence par rapport à la figure 1 réside dans le fait que les moyens de mesure (2) sont en l'espèce plus précisément identifiés, ils sont intégrés à un dispositif connecté à l'entrée de l'appareil de tête de rangée, un interrupteur différentiel (9), et en liaison directe avec une barre de distribution verticale (8) par laquelle est distribuée la totalité du courant de l'installation, dans le sens des flèches qui apparaissent dans ladite barre (8). A cet égard, et en respectant la convention du sens de distribution du courant, les moyens de mesure (6) voient passer le courant distribué dans la totalité des quatre groupes, et effectuent par conséquent la mesure M3= I1+ I2+ I3+ I4, I4 étant le courant véhiculé vers les appareils du groupe 4, mesuré par les moyens de mesure (7), qui donnent la mesure M4= I4.

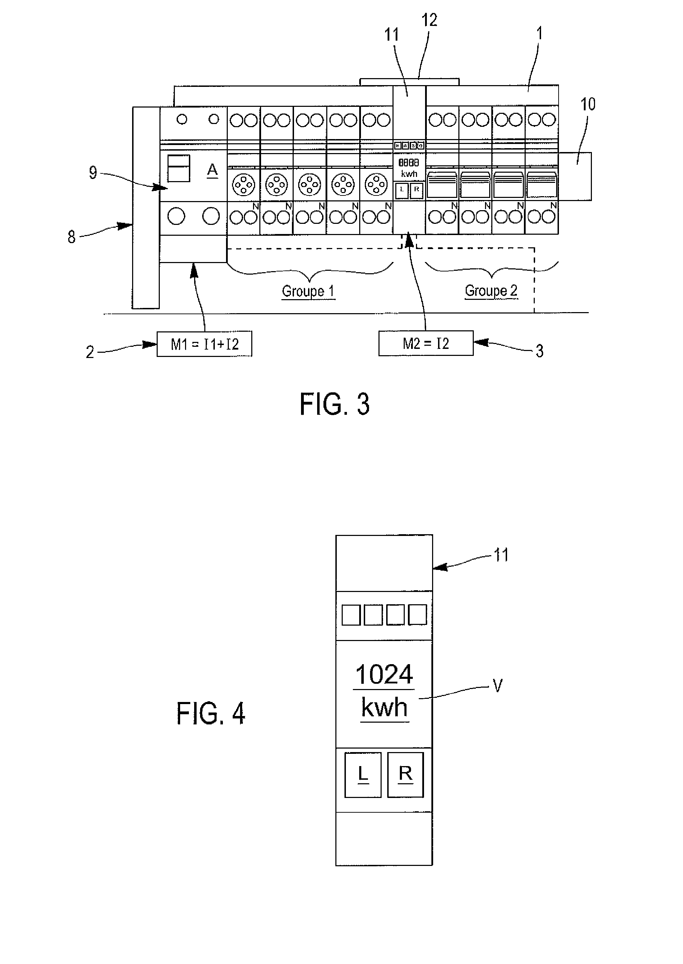

La figure 3 reprend les éléments de la figure 1, en précisant cependant la configuration structurelle des moyens de mesure (2, 3). Dans l'hypothèse représentée, les moyens de mesure (2), qui sont prévus pour collecter la mesure M1 indiquant la somme des courants I1 et I2 parcourant les groupes 1 et 2, sont intégrés à un dispositif placé entre l'entrée de l'interrupteur différentiel de tête (9) et la barre de distribution verticale (8). Le dispositif de mesure (3), correspondant à la mesure M2= I2 du courant véhiculé vers les appareils du groupe 2 est un appareil modulaire (11), situé immédiatement en amont du groupe 2, et fixé sur le rail (10) de la même manière que les appareils des deux groupes 1 et 2, sans qu'il soit nécessaire de recourir à un outil. L'appareil modulaire (11) intègre les premiers moyens de mesure et dispose de conducteurs lui permettant la connexion avec les appareils modulaires adjacents, des deux côtés, conducteurs qui sont en l'espèce logés dans une extension du boîtier (11) d'allure parallèle à l'axe du rail (10) qui permet leur guidage vers les dispositifs de connexion d'entrée desdits appareils contigus.

La barre de pontage (1) est dans cette hypothèse coupée en deux tronçons distincts, de manière à laisser le passage au boîtier de l'appareil de mesure intermédiaire (11).

La figure 4 représente un tel appareil (11), sans l'extension (12) du boîtier, et muni d'un dispositif de visualisation (V) faisant en l'espèce apparaître la consommation d'un des groupes situés à droite ou à gauche. L'appareil de mesure intermédiaire modulaire (11) comporte par ailleurs deux boutons référencés L et R permettant de sélectionner le groupe dont la puissance consommée doit s'afficher dans l'afficheur (V).

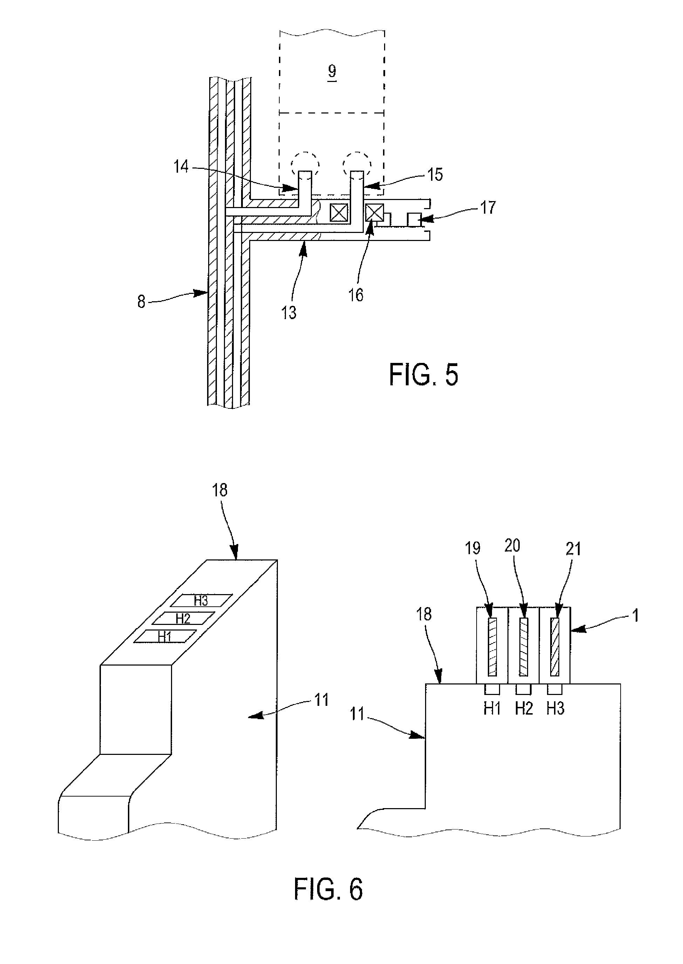

La figure 5 représente une autre possibilité de mise en oeuvre de moyens de mesure entre un appareil de tête d'une rangée (9) et une barre verticale (8) de distribution de la puissance, qui est configuré de la manière suivante : ladite barre (8) comporte, au niveau de chaque rangée d'appareils modulaires, une excroissance (13) entourée d'une enveloppe isolée, logeant des pattes conductrice coudées (14, 15) issues des conducteurs d'alimentation véhiculées par la barre de distribution verticale (8). Les extrémités de ces pattes coudées (14, 15) s'insèrent dans les dispositifs de connexion de l'appareil de tête (9), auxquels elles sont fixées.

Un tore (16) de mesure du courant véhiculé par exemple par la barre de phase (15) est placé autour de cette dernière, dans l'enveloppe isolante (13).

Un dispositif de connexion (17) permet par ailleurs la connexion à un bus de transfert d'informations, sous forme de fils permettant de véhiculer l'information obtenue via le tore (16) vers une unité de traitement (5) telle que montrée en figure 1.

La figure 6 montre une configuration possible pour l'appareil modulaire de mesure intermédiaire (11), sans extension du boîtier. Dans ce cas, la face (18) du boîtier qui est localisée en regard de la barre de distribution (1) comporte un nombre de capteurs à effet Hall (H1, H2, H3) égal au nombre de conducteurs d'alimentation (19, 20, 21) de la barre de distribution (1).

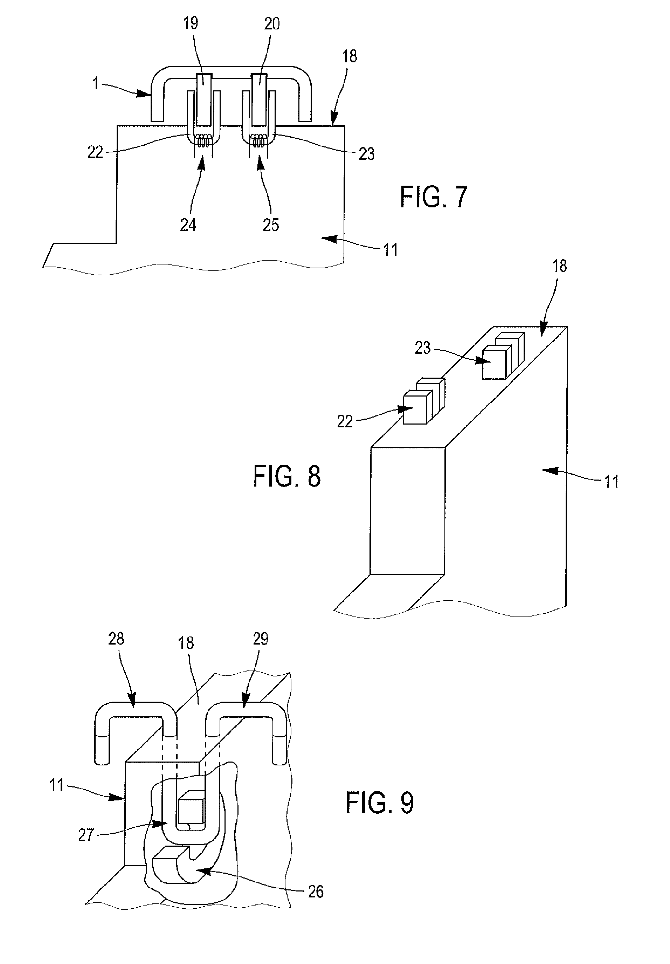

Les figures 7 et 8 représentent une variante à la solution de la figure 6, dans laquelle le moyen de mesure consiste en un nombre de fourches ou tores partiels (22, 23) équivalent au nombre de conducteurs d'alimentation (19, 20) dans la barre (1). Ces fourches ou tores (22, 23) sont entourés par un bobinage (24, 25) qui restitue une mesure du courant passant dans les conducteurs (19, 20), l'ensemble constituant un circuit magnétique suscitant dans les enroulements (24, 25) un courant de mesure proportionnel à celui qui est véhiculé par les conducteurs (19, 20).

Une variante à cette dernière configuration est montrée en figure 9, dans laquelle un tore (26), figuré partiellement coupé, entoure un conducteur (27) dont les extrémités libres (28, 29) sont configurées pour se connecter dans les dispositifs de connexion des deux dispositifs de connexion des deux appareils modulaires adjacents.

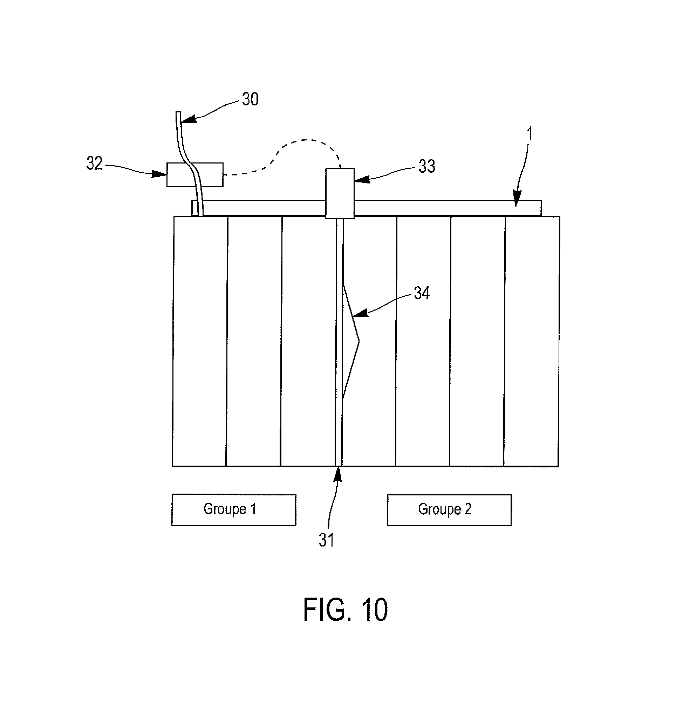

En référence à la figure 10, on y trouve également les éléments de la figure 1, en précisant la configuration structurelle des moyens de mesure (2, 3). Dans l'hypothèse représentée, les moyens de mesure (2), qui sont prévus pour collecter la mesure M1 indiquant la somme des courants I1 et I2 parcourant les groupes 1 et 2, sont directement placés autour du conducteur d'alimentation de la rangée (30), et peuvent être un simple capteur torique (32). Le dispositif de mesure (3), correspondant à la mesure M2= I2 du courant véhiculé vers les appareils du groupe 2 consiste en un boîtier (33) fixé sur la barre d'alimentation (1), au voisinage ou au contact d'au moins une portion de la face latérale en regard de ladite barre (1) du boîtier du premier appareil du groupe. Le système de signalisation visuelle du groupe consiste en une feuille souple (31) issue du boîtier (33) et comportant une portion repliable (34) parallèlement à la façade des appareils modulaires, en direction des appareils constituant le groupe, en l'occurrence le groupe 2.

La barre de pontage (1) est dans cette hypothèse coupée en deux tronçons distincts, de manière à laisser le passage au boîtier (33) du dispositif de mesure.

Comme on l'a déjà mentionné, on pourrait généraliser la configuration montrée notamment en figure 2, à une matrice (n,m) de n groupes de produits sur m rangées, nécessitant par conséquent nxm points de mesure ou capteurs selon les exemples définis auparavant.

La description ci-dessus, qui fait référence aux figures annexées, n'est bien entendu pas exhaustive de l'invention, laquelle englobe au contraire les variantes de formes et de configurations qui sont à la portée de l'homme de l'art.

## Revendications

1. Système de mesure de la consommation électrique d'au moins un groupe constitué d'au moins deux appareils électriques modulaires, lesdits appareils modulaires étant fixés sur au moins un rail en au moins une rangée, un groupe n'appartenant qu'à une rangée, comportant des moyens de mesure du courant et au moins une unité de traitement (5) du ou des courants mesurés, et des moyens de liaison (4) entre les moyens de mesure du courant et ladite unité de traitement (5), **caractérisé en ce qu'il** comporte :
- un dispositif de mesure solidarisé à une rangée de manière amovible, disposé en amont immédiat d'au moins un groupe et doté de premiers moyens de mesure (3, 7) du courant consommé dans ledit groupe ;
- un système de signalisation visuelle (34) du groupe à mesurer, placé au niveau dudit dispositif de mesure ;
- des seconds moyens de mesure (2, 6) du courant pouvant être placés à distance du dispositif de mesure.

2. Système de mesure de la consommation électrique selon la revendication précédente, **caractérisé en ce que** les seconds moyens de mesure du courant consistent en un tore (16, 32) placé autour d'un conducteur d'alimentation (15, 30).

3. Système de mesure de la consommation électrique selon l'une des revendications précédentes, **caractérisé en ce que** les seconds moyens de mesure du courant consistent en un tore placé sur un câble en sortie d'un appareil électrique pour mesurer la consommation d'un seul appareil.

4. Système de mesure de la consommation électrique selon l'une des revendications 1 et 2, **caractérisé en ce que** les seconds moyens de mesure (2, 6) sont placés en début de chaque rangée et sont :
- disposés dans une barre d'alimentation (8) de plusieurs rangées ; et/ou
- disposés dans une barre d'alimentation (1) de plusieurs groupes ; et/ou
- intégrés dans un appareil (9) de tête de rangée ; et/ou
- placés dans un appareil à boîtier modulaire (11) placé entre l'appareil de tête de rangée (9) et le groupe localisé immédiatement en aval ; et/ou
- intégrés à un dispositif (13) connecté à l'entrée de l'appareil de tête de rangée.

5. Système de mesure de la consommation électrique selon l'une des revendications précédentes, **caractérisé en ce que** les moyens de mesure (2, 6) sont reliés à l'unité de traitement par fil (4) ou par liaison radio.

6. Système de mesure de la consommation électrique selon l'une des revendications précédentes, **caractérisé en ce que** le dispositif de mesure du courant consiste en un boîtier (33) fixé sur la barre d'alimentation (1), au voisinage ou au contact d'au moins une portion de la face latérale en regard de ladite barre (1) du boîtier du premier appareil du groupe.

7. Système de mesure de la consommation électrique selon la revendication précédente, **caractérisé en ce que** le système de signalisation visuelle du groupe (31) consiste en une feuille souple issue du boîtier (33) et comportant une portion repliable (34) parallèlement à la façade des appareils modulaires, en direction des appareils constituant le groupe.

8. Système de mesure de la consommation électrique selon la revendication 6, **caractérisé en ce que** le système de signalisation visuelle du groupe (31) consiste en un pictogramme placé sur le boitier indiquant la direction dans laquelle se trouvent, dans la rangée, les appareils constituant le groupe.

9. Système de mesure de la consommation électrique selon l'une des revendications 1 à 5, **caractérisé en ce que** le dispositif de mesure du courant consiste en un appareil (11) à boîtier modulaire.

10. Système de mesure de la consommation électrique selon la revendication précédente, **caractérisé en ce que** les premiers moyens de mesure du courant sont disposés dans la face latérale (18) du boîtier (11) en regard du ou des conducteurs d'alimentation (19, 20, 21) des appareils du groupe localisé en aval.

11. Système de mesure de la consommation électrique selon la revendication précédente, **caractérisé en ce que** les premiers moyens de mesure consistent en au moins un capteur à effet Hall (H1, H2, H3), positionné à proximité immédiate du conducteur (19, 20, 21) dont il doit mesurer le courant.

12. Système de mesure de la consommation électrique selon la revendication 9, **caractérisé en ce que** les premiers moyens de mesure du courant consistent en au moins un tore (22, 23) partiellement ouvert dans la direction des conducteurs d'alimentation (19, 20), dépassant du boîtier (11) de sorte qu'il puisse entourer au moins partiellement au moins un conducteur d'alimentation (19, 20).

13. Système de mesure de la consommation électrique selon la revendication 9, **caractérisé en ce que** les premiers moyens de mesure du courant comportent un conducteur (27) passant dans un tore (26) intégré au boîtier (11) par phase d'alimentation, dont les extrémités libres (28, 29) dépassent de la face latérale (18) du boîtier (11) pour relier deux blocs adjacents par raccordement aux dispositifs de connexion d'entrée des appareils modulaire situés de part et d'autre du boîtier (11) du dispositif de mesure ou à des dispositifs de connexion prévus dans deux portions d'une barre d'alimentation (1) alimentant les deux groupes adjacents.

14. Système de mesure de la consommation électrique selon la revendication précédente, **caractérisé en ce que** lesdites extrémités (28, 29) sont logées dans une extension (12) du boîtier (11) d'allure parallèle à l'axe de la rangée, permettant leur guidage vers les dispositifs de connexion.

15. Système de mesure de la consommation électrique selon l'une quelconque des revendications 6 à 14, **caractérisé en ce que** le dispositif de mesure comporte des moyens de visualisation (V) disposés sur la façade du boîtier (11, 33), et reliés à l'unité de traitement (5) des courants mesurés.

16. Système de mesure de la consommation électrique selon la revendication précédente, **caractérisé en ce que** les moyens de visualisation (V) consistent en un écran LCD.

17. Système de mesure de la consommation électrique selon l'une quelconque des revendications 6 à 14, **caractérisé en ce que** le dispositif de mesure (11, 33) comporte des moyens de commande du groupe dont la consommation mesurée doit être affichée.

18. Système de mesure de la consommation électrique selon la revendication précédente, **caractérisé en ce que** les moyens de commande consistent en deux boutons (L, R) alignés selon l'axe de la rangée et permettant d'indiquer le côté du groupe sélectionné.
